# EUROPEAN PATENT SPECIFICATION

(11) **EP 3 824 488 B1**
(45) Date of publication and mention of the grant of the patent: **12.07.2023**
(21) Application number: 19721313.5
(22) Date of filing: 07.05.2019
(51) Int. Cl.: H01G 9/20, H01L 31/02, H02J 7/35

(54) **A DYE-SENSITIZED SOLAR CELL UNIT, A PHOTOVOLTAIC CHARGER INCLUDING THE DYE-SENSITIZED SOLAR CELL UNIT AND A METHOD FOR PRODUCING THE SOLAR CELL UNIT**
FARBSTOFFSENSIBILISIERTE SOLARZELLENEINHEIT, FOTOVOLTAISCHES LADEGERÄT MIT DER FARBSTOFFSENSIBILISIERTEN SOLARZELLENEINHEIT UND VERFAHREN ZUR HERSTELLUNG DER SOLARZELLENEINHEIT
UNITÉ DE CELLULE SOLAIRE SENSIBLE À UN COLORANT, CHARGEUR PHOTOVOLTAÏQUE COMPRENANT L'UNITÉ DE CELLULE SOLAIRE SENSIBLE À UN COLORANT ET PROCÉDÉ DE PRODUCTION DE L'UNITÉ DE CELLULE SOLAIRE

(30) Priority: 16.07.2018 EP 18183590; 10.01.2019 SE 1950025
(43) Date of publication of application: 26.05.2021
(73) Proprietor: Exeger Operations AB, 102 04 Stockholm (SE)
(72) Inventor: LINDSTRÖM, Henrik, 182 35 Danderyd (SE); FILI, Giovanni, 182 56 Danderyd (SE)
(74) Representative: Swea IP Law AB
(86) International application number: PCT/EP2019/061728
(87) International publication number: WO 2020/015882

(56) References cited:
- WO-A1-2013/053501
- WO-A1-2013/149787
- JP-A- 2007 324 080
- US-A1- 2019 148 083
- US-B1- 6 291 763

## Description

### Technical field

The present invention relatesto a dye-sensitized solar cell unit. The present invention further relates to a photovoltaic charger specially adapted for charging an electronic device including the dye-sensitized solar cell unit.

### Background

Solar cells have been used during a long time for converting the energy of light into electricity. Solar panels are used to absorb sunlight as a source of energy to generate electricity. A solar panel contains multiple solar cells connected in series. A large number of solar panels are often arranged together in large solar parks for producing electricityto an electricity supply network.

Solar cells are becoming more and more efficient as well as cheaper to produce. So, naturally, companies are making all sorts of consumer products powered at least in part by solar cells. Many portable electronic devices are today provided with built-in rechargeable batteries which store energy, and photovoltaic chargers arranged to supply power to the batteries for charging them. A photovoltaic charger or a solar charger employs solar energy to supply electricity to the devices and to charge batteries. Examples of such portable devices are tablets, mobile phones, head phones and calculators. When solar cells are used, the battery of the device is complemented so that the use time is increased before there is a need to charge the device from an external source. Depending on the efficiency of the photovoltaic charger and the power consumption of the device, the need for charging the device with an external source may even be obsoleted and the device is then only powered by solar power. For example, small calculators are often powered solely by photovoltaic chargers.

Photovoltaic chargerswhich are on the market today use various types of solar panels, ranging from thin film panels with efficiencies ranging from 7-15%, to the slightly more efficient monocrystalline panels which offer efficiencies up to 18%. The efficiency is usually tested using Standard Testing Conditions, STC, which is the industry standard for the conditions under which solar panels are tested. In the STC, the irradiation is 1000 W/m², the temperature is 25°C and the Air Mass is 1.5. As an example, a solar panel giving an output power of 200 W/m² has an efficiency of 20%. These conditions simulate what the efficiency of a solar panel is in outside conditions on a summer day with no clouds. The wavelength spectrum of indoor light differs from the wavelength spectrum of outdoor light. For example, wavelengths outside the visible range is often missing in indoor light since glass windows filter UV light and indoor lamps mainly produce light in the visible range. Thus, the efficiency of a solar panel measured in outside conditions cannot be applied to indoor conditions. The typical human eye will respond to wavelengths from about 390 to 700 nm, and indoor light is mostly within the visible spectrum.

In the article "Comparison of the indoor performance of 12 commercial PV products by a simple model" by Georgia Apostolou et al. it is explained how indoor lighting differs from outdoor lighting. The author of the article states that in case of a double-glass insulated window, the decrease in the radiant power at 1 and 5 m from the window will be around 70% and 97%, respectively. The article shows that solar panels today lose a lot of their efficiency in indoor lighting. Hence, a disadvantage with those solar panels is that they have low efficiency at low light intensities.

Other disadvantages with existing solar cell panels for powering electronic devices are that some of them are toxic, have bad mechanical properties and are expensive.

GB2510451(A) by OnBeat Ltd. shows a pair of head phones powered by solar cells. A flexible solar panel is provided on the outer surface of the headband and on the earpieces. The head phones can also be used to power an external device with stored solar power. It is visually apparent to the onlooker that the OnBeat headband is covered by a panel of solar cells, but the type of solar cell is not specified.

The demands on solar panels for powering consumer products are quite different compared to stationary solar panels used for producing electricity in large solar parks. For example, the solar panel in a consumer product needs to be more robust, flexible and able to resist impacts. Further, they must be able to produce power at various light conditions, both indoors and outdoors. The light conditions on different parts of the solar panel may also differ due to partial shading of the solar panel, which reduces the efficiency of the solar panel. It is also desired that the solar panels have an aesthetic appeal, since they are visible to the user.

It should be noted that there are many examples of photovoltaic chargers having a solar panel including a plurality of solar cells connected in series for powering portable electronic devices. However, there are several problems with the known solar panels powering the portable electronic devices: they are very sensitive to light intensity and the angleof the incoming light. A solar panel with solar cells connected in series is sensitive to partial shading because if one solar cell is not producing a current, the whole series of solar cells will stop producing electricity. They are quite sensitive and are easily broken. For example, crystalline silicon solar cells are brittle and may crackwhen used on a portable electronic device. Furthermore, users may not agree with the aesthetics where large parts of the product are covered by solar panels having a grid of visible current collectors on the upper side. Thus, there is a need to improve the photovoltaic chargers for use with portable electronic devices.

WO2013/149787 discloses a dye-sensitized solar cell module having a serial structure comprising a plurality of dye-sensitized solar cell units arranged adjacent to each other and connected in series. Each cell unit includes a working electrode, a first conductive layer for extracting photo-generated electrons from the working electrode, a counter electrode including a second conductive layer, electrolyte for transferring electrons from the counter electrode to the working electrode, and a series connecting element for electrically connecting the counter electrode to a working electrode of an adjacent cell unit. The solar cell module comprises a porous insulating substrate, the first conductive layer is a porous conductive layer formed on one side of the porous insulating substrate, and the second conductive layer is a porous conductive layer formed on the opposite side of the porous insulating substrate, and the series connecting element is a conductive layer penetrating through the porous insulating substrate and extending between the first conductive layer of one of the cell units and the second conductive layer of the adjacent cell unit, thereby electrically connecting the first conductive layer of one of the cell units with the second conductive layer of the adjacent cell unit.

WO2014/184379 discloses a dye sensitized solar cell having conductive particles forming a conductive network through the insulating material in the porous insulating substrate. The particles form one or more electrically conductive paths through the insulating material of the insulating substrate. The conductive particles can also be catalytic. Due to the conductive network in the insulating substrate, the distance between the counter electrode and the light-absorbing layer does no longer depend on the thickness of the porous substrate. Thus, the thickness of the insulating part can be reduced, and by that the distance between the counter electrode and the light-absorbing layer can be reduced. Accordingly, resistive losses in the conductive medium are reduced. Due to the fact that the distance between the counter electrode and the light-absorbing layer does no longer depend on the thickness of the whole porous substrate but only on the insulating part, it is also possible to use a substrate that is thick enough for safe mechanical handling. Dye-sensitized solar cells are also disclosed in patent documents WO 2013/053501 A1 and US 6 291 763 B1.

### Summary

The aim of the present invention is to at least partly overcome the above problems, and to provide an improved dye-sensitized solar cell and photovoltaic charger suitable for charging electronic devices for consumer applications, and more particularly for charging rechargeable batteries of the electronic devices.

This aim is achieved by a dye-sensitized solar cell as defined in claim 1.

The dye-sensitized solar cell unit comprises:
- a working electrode comprising a porous light-absorbing layer,
- a porous first conductive layer including conductive material for extracting photo-generated electrons from the light-absorbing layer, wherein the light-absorbing layer is arranged on top of the first conductive layer,
- a porous insulating layer made of an insulating material, wherein the first conductive layer is formed on one side of the porous insulating layer,
- a counter electrode comprising a porous catalytic conductive layer formed on the opposite side of the porous insulating layer, and
- an ionic based electrolyte for transferring electrons from the counter electrode to the working electrode and arranged in pores of the porous first conductive layer, the porous catalytic conductive layer, and the porous insulating layer, wherein the first conductive layer comprises an insulating oxide layer formed on the surfaces of the conductive material, and the porous catalytic conductive layer comprises conductive material and catalytic particles distributed in the conductive material for improving the transfer of electrons from the conductive material to the electrolyte. The thickness of the insulating oxide layer is betwee n 10 and 200 nm, and the solar cell unit generates a voltage varying less than 40 % when the light intensity received by the light-absorbing layer (10) is varying between 200 and 50 000 Lux.

With an ionic based electrolyte is meant an electrolyte comprising ions as carrier for the electrons. An advantage with using an ionic based electrolyte is that it can render high long-term stability to the solar cell performance. Another advantage is that the efficiency of the solar cell unit is stable or increases with increasing temperature. Accordingly, the solar cell unit operates well in a wide range of temperatures.

The electrolyte is disposed within pores of light-absorbing layer, the first conductive layer, the catalytic conductive layer, and the porous insulation layer. The electrolyte comprises ions that transport electrons from the counter electrode to the light-absorbing layer of the working electrode. The insulating oxide layer provides an electrically insulating layeron the conductive material of the first conductive layer, which oxide layer at least partly prevents transfer of electrons between the conductive material and the electrolyte disposed in the pores of the first conductive layer. Accordingly, more electrons reach the light-absorbing layer and by that the efficiency of the solar cell unit increases.

The catalytic particles are made of a material that is different from the conductive material of the catalytic conductive layer. The catalytic particles work as catalysts and facilitates the transfer of the electrons from the conductive material to the electrolyte in the pores of the catalytic conductive layer. The conductive material of the catalytic conductive layer is essentially non-catalytic., i.e. only inconsequential, catalytic reactions at most may occur in the conductive material. The electrons are gained by ions in the electrolyte in the catalytic conductive layer. By distributing the catalytic particles in the conductive material, the transfer of electrons from the conductive material is improved and accordingly the efficiency of the solar cell unit is increased. Further, by locating the catalytic particles as close as possible to the working electrode, the distance the ions in the electrolyte must travel to reach the working electrode is reduced. Thus, the effective distance between the working electrode and the counter electrode is reduced, and accordingly the resistive losses in the electrolyte are reduced resulting in a higher efficiency of the solar cell unit. A further advantage achieved with the reduced distance is that it enables the use of conductive media having low electrical conductivity, such as ionic liquid electrolytes.

The combination of the insulating oxide layer that prevents electrons from leaking from the conductive material to the electrolyte in the pores of the first conductive layer, and a counter electrode comprising a catalytic conductive layer comprising catalytic particles distributed in the conductive material the improves the transfer of electrons to the electrolyte in the counter electrode, will result in an efficient solar cell unit.

Further, during the manufacturing of the solar cell unit, heat treatment of the solar cell unit in air will result in an oxide layer on the conductive material of the first conductive layer as well as on the conductive material of the catalytic conductive layer. It can be assumed that the oxide layer on the conductive material of the catalytic conductive layer would prevent the electrons from being transferred from the conductive material to the electrolyte disposed in the pores of the catalytic conductive layer. Surprisingly, it has been discovered that catalytic particles, such as platinized carbon particles, distributed in the conductive material enable transfer of electrons from the conductive material to the electrolyte despite the oxide layers on the conductive material.

The catalytic conductive layer is conductive as well as catalytic. The electrolyte can be arranged in pores of the entire catalytic conductive layer or only in an upper part of the catalytic conductive layer.

In one aspect, the counter electrode comprises a second conductive layer including conductive material in electrical contact with the catalytic conductive layer, wherein the second conductive layer is essentially non-catalytic, and the porous catalytic conductive layer is disposed between the porous insulating layer and the second conductive layer.

In this aspect, the dye-sensitized solar cell unit comprises:
- a working electrode comprising a porous light-absorbing layer,
   - a first conductive layer comprising a conductive material for extracting photo-generated electrons from the light-absorbing layer, wherein the light-absorbing layer is arranged on top of the first conductive layer,
   - a porous insulating layer made of an insulating material, wherein the first conductive layer is formed on one side of the porous insulating layer,
   - a counter electrode comprising:
      i. a second conductive layer including conductive material, and
      ii. a porous catalytic conductive layer disposed between the porous insulating layer and the second conductive layer, and in electrical contact with the second conductive layer, and
   - an ionic based electrolyte arranged in pores of the first conductive layer, the catalytic conductive layer, and the porous insulating layer for transferring electrons from the counter electrode to the working electrode, wherein the first conductive layer comprises an insulating oxide layer formed on the surfaces of the conductive material, the second conductive layer is essentially non-catalytic, and the catalytic conductive layer comprises conductive material and catalytic particles distributed in the conductive material for improving the transfer of electrons to the electrolyte.

The second conductive layer is made of a conductive material. The second conductive layer can be porous or non-porous. Preferably, the second conductive layer excludes catalytic particles. The second conductive layer is in itself essentially non-catalytic, i.e. only inconsequential, catalytic reactions at most may occur in the second conductive layer. The second conductive layer may contain minor amount of catalytic material. However, the catalytic reactions are concentrated to the catalytic conductive layer. It is preferred that the electrons are transferred to the electrolyte in the catalytic conductive layer due to its shorter distance to the working electrode.

Due to the fact that the second conduction layer is essentially non-catalytic, the electrical conductivity of the second conductive layer can be higher than the electrical conductivity of the catalytic conductive layer. Thus, the combination of a catalytic conductive layer including catalytic particles, and a second conductive layer that is essentially non-catalytic, will result in efficient transfer of electrons from the counter electrode to the electrolyte as well as provide high electrical conductivity of the counter electrode. Further, due to the fact that the second conductive layer is essentially non-catalytic, it is more difficult for the electrons to be transferred to an electrolyte in the second conductive layer.

When the solar cell unit is in use, the second conductive layer receives electrons from an external circuit and distributes the electrons to the catalytic conductive layer. The catalytic particleswork as catalysts and facilitate the transfer of the electrons received from the second conductive layer to the electrolyte in the pores of the catalytic conductive layer. By locating the catalytic particles as close as possible to the working electrode, the distance the ions in the electrolyte must travel to reach the working electrode is reduced. Accordingly, the power losses in the solar cell unit are reduced, and thus the efficiency of the solar cell unit is further increased. The second conductive layer ensures an efficient distribution of electrons to the catalytic conductive layer.

In particular, the combination of the insulating oxide layer that prevents electrons from leaking from the conductive material to the electrolyte in the pores of the first conductive layer, and a counter electrode comprising a catalytic conductive layer, and a non-catalytic second conductive layer, which improves the efficiency of the counter electrode, will result in an efficient solar cell unit that is capable of producing power in a wide range of different light conditions. The solar cell unit works during poor as well as excellent lighting conditions, for example, indoors in artificial light, and outdoors in the shadow and when exposed to strong sunlight.

In one aspect, the conductive material of the second conductive layer is titanium or an alloy thereof. In one aspect, the first and second conductive layers comprise titanium or an alloy thereof. It is advantageous to use titanium since it is highly corrosion resistant and can resist high temperatures, which is advantageous during production of the solar cell unit.

The catalytic particles are made of a catalytic material, for example, carbon-based materials such as graphene or graphite or carbon black or carbon nanotubes, platina or a combination thereof. The catalytic particlescan be electrically conductive as well as catalytic. In one aspect, the electrical conductivity of the catalytic particlesis lower than the conductivity of the second conductive layer.

For example, the electrolyte is an ionic liquid electrolyte.

In one aspect, the catalytic particles are substantially evenly distributed in the catalytic conductive layer.The term "substantially evenly distributed" meansthat the catalytic particles are distributed over the entire area of the catalytic conductive layer. Thus, the catalytic particles are not concentrated to only one or a few parts of the catalytic conductive layer. Although, the concentration of catalytic particles may vary over the area of the catalytic conductive layer, there are no major areas without any catalytic particles. The electrolyte is filled in the pores of the porous catalytic conductive layer. By distributing the catalytic particles substantially evenly in the catalytic conductive layer, transfer of electrons from the conductive material of the catalytic conductive layer to the electrolyte is achieved over the entire area of the catalytic conductive layer and accordingly transfer of electrons from the conductive particles to the electrolyte is improved.

In one aspect, the conductive material of the porous catalytic conductive layer forms a porous matrix and the catalytic particles are distributed in the porous matrix. With a porous matrix is meant a porous layer including a network of interconnected conductive particles that form conductive paths though the porous layer. Preferably, the catalytic particles are substantially evenly distributed in the porous matrix. The catalytic particles are embedded in the porous matrix. For example, the porous matrix is a layer of sintered conductive particles and the catalytic particles are disposed between the conductive particles. The porous matrix houses the catalytic particles and keeps them in place. The porous matrix may act as a glue between the catalytic particle and holds them in place.

In one aspect, the conductive material of the first conductive layer is porous titanium, and the insulating oxide layer is a titanium oxide formed on the surfaces of the porous titanium. The first conductive layer comprises a titanium oxide layer formed on the surfaces of the porous titanium and covering the surfaces of the porous titanium. The titanium oxide layer prevents electrons from leaking from the porous titanium in the first conductive layerto the electrolyte in the pores of the first conductive layer, and accordingly increases the efficiency of the solar cell unit. In one aspect, the porous titanium comprises sintered titanium particles, and the surfaces of the sintered titanium particles are covered by the titanium oxide layer.

In one aspect, the catalytic conductive layer comprises between 1-50% by weight of catalytic particles. The % by weight of catalytic particles needed to achieve an efficient transfer of electrons from the conductive material to the electrolyte depends on the size and shape of the catalytic particles and the type of material in the catalytic particles and the type of conductive material.

In another aspect, the catalytic conductive layer comprises between 1 - 30 % by weight of catalytic particles. This range is, for example, suitable when the conductive particles consist of titanium and the catalytic particles consist of platinized carbon. However, as mentioned before, the % by weight of catalytic particles depends on the size of the particles.

In one aspect, the catalytic conductive layer comprises at least 1 % by weight of catalytic particles. In one aspect, the catalytic conductive layer comprises at least 5 % by weight of catalytic particles. In one aspect, the catalytic conductive layer comprises at least 10 % by weight of catalytic particles.

In one aspect, the catalytic conductive layer comprises more than 50% by weight of conducting material, and less than 50 % by weight of catalytic particles.

The term "NN % by weight" means that the particles represent NN % of the total weight of conductive and catalytic particles. The actual % by weight of catalytic/conductive particles depends on the difference in size between the catalytic and the conductive particles, and on the type of material in the catalytic and conductive particles.

The conductive material of the catalytic conductive layer is, for example, metal, metal alloy, metal oxide, or other conductive materials, for example, titanium, titanium alloys, nickel, or nickel alloys, indium or indium oxide.

In one aspect, the conductive material of the catalytic conductive layer is titanium. For example,the conductive material of the catalytic conductive layer com prises sintered titanium pa rticles.

In one aspect, the catalytic particles comprise carbon. Carbon is catalytic material. Carbon is inexpensive and environmentally friendly.

In one aspect, the catalytic particles comprise platinized carbon particles. Platina is a better catalystthan carbon, but it is expensive. By using a combination of platina and carbon, a good catalyst is achieved at a lower cost.

In one aspect, the conducting material of the catalytic conductive layer istitanium, and the catalytic particles are platinized carbon particles. With the term "platinized carbon particles" is meant particles having a core of carbon coved with a layer of platina. Plati na is a good catalyst. However, a problem with platina it that it is difficult to attach to titanium. Platina can easily be attached to carbon. However, a problem with carbon is that it has bad mechanical strength. Those problems are solved by distributing platinized carbon particles in a matrix of titanium. Titanium has good mechanical strength and keeps the platinized carbon particles in their positions in the catalytic conductive layer. Thus, carbon, platina and titanium together provide a catalytic conducting layer with high mechanical strength and a high ability to transfer electrons to the electrolyte.

In one aspect, the catalytic conductive layer comprises between 50 and 90 % by weight of titanium. In one aspect, the catalytic conductive layer comprises at least 5 % by weight of carbon, and preferably at least 10 % by weight of carbon. In one aspect, the catalytic conductive layer comprises at least 0.001 % by weight of platina.

In one aspect, the catalytic conductive layer comprises a mixture of conductive particles and catalytic particles. The conductive particles are in electrical contact with the second conductive layer. The catalytic particles are mixed with the conductive particles to improve the transfer of electrons from the conductive particles to the electrolyte. The conductive particles are made of a conductive material. Preferably, the conductive particles are non-catalytic and excludes catalytic material. The mixture of conductive particles and catalytic particles will result in efficient transfer of electrons from the catalytic conductive layer to the electrolyte. The catalytic particles are distributed among the conductive particles. The conductive particles may form a matrix housing the catalytic particles and keeping them in place.

In one aspect, the catalytic particlesare substantially evenly distributed among the conductive particles. By distributing the catalytic particles substantially evenly in the catalytic conductive layer, transfer of electrons from the conductive particles to the electrolyte is improved.

In one aspect, the conductive particles are attached to each other, for example, by sintering. The conductive particle may form a matrix housing the catalytic particles. The catalytic particles are embedded in the matrix of conductive particles. For example, the catalytic conductive layer comprises sintered conductive particles, and catalytic particles disposed between the conductive particles. The conductive particles act as a glue between catalytic particles and keep the catalytic particles in positions between the conductive particles.

In one aspect, the size of the conductive particles is larger than the size of the catalytic particles. When the catalytic material is more expensive than the conductive material, it is advantageous that the size of the catalytic particles is less than the size of the conductive particles in order to save costs.

In one aspect, at least 80% of the catalytic particles have a diameter less than 50 nm. Such small particles have a large surface/volume ratio and will provide an efficient catalyzation with a reduced volume of catalytic material. If the catalytic material is platina, this will reduce the cost for the catalytic material.

In one aspect, at least 80% of the conductive particles have a diameter larger than 100 nm. Preferably, the size of conductive particles between 0.1 -15 µm.

In one aspect, the catalytic conductive layer comprises a mixture of titanium particles and platinized carbon particles. Preferably, the titanium particles are attached to each other, for example, by sintering.

In one aspect, the conductive material in the porous catalytic conductive layer are the same material as is used in the second conductive layer.

In one aspect, the thickness of the catalytic conductive layer is less than 100 µm, and preferably less than 20 µm. In one aspect, the thickness of the catalytic conductive layer is at least 1 µm, preferably at least 5 µm and most preferably at least 10 µm.

In one aspect, the thickness of the second conductive layer is at least 1 µm, preferably at least 10 µm and preferably at least 20 µm.

The thickness of the first conductive layer is advantageously also kept thin in order to have a short distance between the light-absorbing layer and the catalytic conductive layer and the counter electrode. The thickness of the first conductive layer can be between 0.1 and 40 µm, and preferably between 0.3 and 20 µm.

In one aspect, the porous insulating layer comprises a porous substrate made of an insulating material.

In one aspect, the porous catalytic conductive layer comprises a porous substrate made of an insulating material, and the conductive particles of the catalytic conductive layer form a conductive network through the insulating material of the porous substrate. The conductive particles and the catalytic particles are disposed in pores of the porous substrate. The conductive network provides an extension of the counter electrode, which extends into the porous substrate.

With the term "the conductive particles form a conductive network through the insulating material" is meant that the particles form one or more electrically conductive paths through the insulating material of the porous substrate.

In one aspect, the dye-sensitized solar cell unit comprises a porous substrate made of an insulating material, the porous insulating layer is a first part of the porous substrate and the conductive particles of the catalytic conductive layer form a conductive network through a second part of the porous substrate. Due to the conductive network in the porous substrate, the distance between the counter electrode and the light-absorbing layer does no longer depend on the thickness of the porous substrate. Thus, the thickness of the insulating layer can be reduced, and by that the distance between the counter electrode and the light-absorbing layer can be reduced.

The porous insulating layer prevents short circuit between the first conductive layer and the catalytic conductive layer. The conductive particles in the catalytic conductive layer form a conductive network through the insulating material of the substrate. The conductive network is in electrical contact with the second conductive layer of the counter electrode and will therefore significantly increase the conductive surface area of the counter electrode.

In one aspect, the electrolyte is any of an iodide/triiodide electrolyte, a copper complex-based electrolyte, or a cobalt complex-based electrolyte, or a combination thereof.

In one aspect, the conductive medium comprises iodide (I⁻) and triiodide (I₃⁻) and the content of triiodide in the conductive medium is between 1 mM and 20 mM. This embodiment makes it possible to achieve high power generation at low light intensities.

In one aspect, the porous substrate is a sheet comprising woven microfibers extending through the entire solarcell unit. For example, the woven microfibers are made of glass fibres. The sheet comprising woven microfibers extending through the entire solar cell unit contributes to provide a flexible, twistable, and impact resistant photovoltaic charger.

In one aspect, the porous light-absorbing layer includes dyed TiO₂. A porous light-absorbing layer including dyed TiO₂ is non-brittle and is not dependent on the angle of the incoming light.

In one aspect, the light-absorbing layer is a porous TiO2 nanoparticle layer with adsorbed organic dye. Examples of organic dyes are: N719, N907, B11, C101. Also, other organic dyes can be used.

In one aspect, the solar cell unit produces at least 5 µW/cm²when the light intensity received by the light-absorbing layer is 200 Lux, and at least 600 µW/cm² when the light intensity received by the light-absorbing layer is 20 000 Lux. The solar cell unit produces more than 5 µW/cm² measured on active solar cell area, when the light intensity received by the light-absorbing layer is 200 Lux. It has been proven through tests that the solar cell unit according to the invention iscapable of producing more than 5 µW/cm² when the light intensity received by the light-absorbing layer is 200 Lux. Lux is a suitable unit for measuring light intensity since it measures the intensity of light perceived by the human eyes. Lux is commonly used to measure the intensity of indoor light, which is mostly within the part of electromagnetic spectrum that is visible to the human eye. Accordingly, it is suitable to relate the efficiency of the solar cell unit to the light intensity measured in Lux.

In one aspect, the solar cell unit produces more than 5.5 µW/cm² when the light intensity received by the light-absorbing layer is 200 Lux. It has been proven through tests that the sola r cell unit according to the invention is capable to produce more than 5.5 µW/cm² when the light intensity received by the light-absorbing layer is 200 Lux.

In one aspect, the solar cell unit produces at least 150 µW/cm² when the light intensity received by the light-absorbing layer is 5 000 Lux.

In one aspect, the solar cell unit produces at least 600 µW/cm², and preferably at least 700 µW/cm² when the light intensity received by the light-absorbing layer is 20 000 Lux. More particularly, the solar cell unit is capable of producing at least between 5 and 600 µW/cm² when the light intensity received by the light-absorbing layer is between 200 and 20 000 Lux. The power produced by the solar cell unit increases substantially linearly when the light intensity received by the light-absorbing layer increases from 200 to 20 000 Lux. Thus, the solar cell unit is capable of producing power in a wide range of different light conditions. The solar cell unit works during poor as well as excellent lighting conditions, for example, indoors in artificial light, outdoors in the shadow and when exposed to strong sunlight.

With substantially linear is meant that the power produced increases linearly with increasing light intensity at least in a main part of the interval 200 and 20 000 Lux. For example, the power produced may differ slightly from linear with intensities between 200 and 1000 Lux.

The solar cell unit generates a voltage varying less than 40 %, when the light intensity received by the light-absorbing layer varies between 200 and 50 000 Lux. For example, the solar cell unit generates a voltage varying less than 0.4 V, and preferably less than 0.3 V, when the light intensity received by the light-absorbing layer varies between 200 and 50 000 Lux. The voltage generated by the solar cell unit is quite even in the interval 200 to 50 000 Lux. This means that the produced voltage is fairly independent of the light intensity. Due to the fact that the voltage output from the solar cell unit only varies a little when the light intensity received by the light-absorbing layer varies between 200 and 50 000 Lux, it is possible to use a boost converter to step up the voltage for a wide range of different light intensities without extensive loss during the conversion.

The level of the generated voltage depends on the ions in the electrolyte. For example, if the electrolyte contains copper ions, the solar cell unit can generate a voltage of about 1 V in an open circuit when the light intensity received by the light-absorbing layer is 20 000 Lux, and if the electrolyte contains iodide and triiodide ions, the solar cell unit can generate a voltage of 0.65 V in an open circuit when the light intensity received by the light-absorbing layer is 20 000 Lux.

In one aspect, the solar cell unit generates a voltage of at least 0.3 V in an open circuit when the light intensity received by the light-absorbing layer is 200 Lux.

Further, the solar cell unit generates a voltage less than 1.2 V in an open circuit when the light intensity received by the light-absorbing layer is 20 000 Lux.

In one aspect, the current produced by the solar cell unit increases linearly when the light intensity received by the light-absorbing layer increases from 200 to 20 000 Lux.

In one aspect, the solar cell unit produces a current of at least 15 µA/cm² when the light intensity received by the light-absorbing layer is 200 Lux, and the current produced by the solar cell unit is linearly increasing when the light intensity received by the light-absorbing layer increases from 200 to 20 000 Lux. Due to the linearity, and the fact that the solar cell unit does not produce any current when the light intensity is zero and produces a current of at least 15 µA/cm² when the light intensity is 200 Lux, the solar cell unit produces a current of about 1500 µA/cm² when the light intensity received by the light-absorbing layer is 20 000 Lux. Thus, the solar cell unit is capable of producing sufficient power to charge batteries of electronic devices in a wide range of light intensities.

The solar cell unit is preferably a monolithic dye-sensitized solar cell. A monolithic dye-sensitized solar cell is characterized in that all layers are directly or indirectly deposited on one and the same porous substrate.

The first and second conductive layers are positioned on a shadow side of the light-absorbing layer, i.e. the side opposite the side receiving the light. Thus, the first and second conductive layers are positioned on the same side of the light-absorbing layer.

Another object of the present invention is to provide a photovoltaic charger specially adapted for charging an electronic device.

This object is achieved by a photovoltaic charger comprising a dye-sensitized solar cell unit according to the invention, an encapsulation encapsulating the solarcell unit, a first conductor electrically connected to the first conductive layer, and at least one second conductor electrically connected to the second conductive layer, wherein the photovoltaic charger contains only one single solar cell unit and a boost converter electrically connected to the first and second conductors, and the boost converter is adapted to step up the voltage from the solar cell unit while stepping down the current from the solar cell unit.

The photovoltaic charger according to the invention is capable of charging devices when the light conditions are very poor. For example, the photovoltaic charger is capable of charging the electronic devices when the only light source is a lamp. This makes it possible to charge electronic devices indoors at night.

Furthermore, since the photovoltaic charger has only one single solar cell unit, there will be no problems from partial shading. Even if parts of the surface of the solar cell unit are shaded, the non-shaded parts will still produce a current. Thus, the photovoltaic charger according to the invention is still capable of charging the electronic device even when the active area of the photovoltaic charger is partially shaded. With active area is meant the area of the solar cell unit, which contributes to produce power when it is exposed to the light.

The first conductor works as a current collector and collects currents from the first conductive layer. The second conductor works as a current distributor and distributes currents to the second conductive layer. The photovoltaic charger has one single scalable solar cell which can be adapted to any shape or size of a portable electronic device. There is no need for a plurality of current collectors arranged across the visible side of the photovoltaic charger, and the absence of visible current collectors result in a visually homogenous surface. Thus, the photovoltaic charger can be used on the portable electronic device without affecting the design of the device. In other words, a portable electronic device can be powered by the photovoltaic charger without it being visible to the onlooker. Another advantage with not having many connection elements arranged over the surface of the solar cell unit is that more area of the solar cell unit can be used for generating power since there are not a plurality of current collectors blocking the incoming light.

Further advantages with the photovoltaic charger include low costs, impact resistance, flexibility, and independence of the angle of the incoming light.

Further, the size of the single solar cell unit is scalable, and accordingly the size and power of the photovoltaic charger can be adapted to the size and power demand of different devices to be charged. By increasing the area of the solar cell unit, the power generated by the photovoltaic charger is increased.

The photovoltaic charger comprises a boost converter electrically connected to the first and second conductors and the boost converter is adapted to step up the voltage from the solar cell unit while stepping down the current from the solar cell unit. Thus, the photovoltaic charger is capable to generate a sufficient voltage level for charging electronic devices in a wide range of different light conditions. Different types of batteries require different voltage levels. The boost converter makes it possible to provide rechargeable batteries of electronic devices with the voltage level needed by the type of battery. The voltage produced by the single solar cell unit is too low to charge certain types or batteries, for example, lithium batteries that require about 3.6 V. In the prior art, the required voltage is achieved by arranging a plurality of solar cell units connected in series. According to the invention, the required voltage is achieved by connecting a boost converter to the single solar cell unit. Thus, it is possible to provide a photovoltaic charger having only one solar cell unit capable to charge batteries that require different voltage levels.

In one aspect, the boost converter is configured to convert the voltage from the solar cell unit to a voltage that lies between 1 and 10 V. Thus, the photovoltaic charger is capable of charging batteries used for many types of electronic devices for consumer applications, such as lithium or nickel-based batteries.

In one aspect, the boost converter is configured to convert a voltage between 0.25 and 1 V to a voltage above 3 V, and preferably above 3.5 V. Thus, the photovoltaic charger can be used to charge a battery having a load voltage above 3 V, such as a lithium battery that typically requires a load voltage between 3 and 4,5 V depending on how loaded the battery is.

In one aspect, the boost converter is capable to handle currents between 15 and 9000 mA/cm². Thus, the boost converter is capable to handle currents from the solar cell unit from 200 lux to 120 000 lux, which is full sunlight.

In one aspect, the encapsulation is made of a transparent plastic. This feature contributes to provide a flexible, twistable, and impact resistant photovoltaic charger.

According to some aspects, the shape and size of the single solar cell unit is adapted to the size and shape of the portable electronic device it is powering. Further, the active area of the solar cell unit is adapted to the power needed to charge the device.

In one aspect, the shortest distance from side to side of the active area of the solar cell unit is larger than 1 cm, and preferably larger than 1.5 cm.

In one aspect, the shortest distance from side to side of the active area of the solar cell unit is larger than 1.5, and the active area of the solar cell unit is larger than 25 cm². Such a photovoltaic charger is, for example, useful for charging head phones.

In one aspect, the shortest distance from side to side of the active area of the solar cell is largerthan 10 cm. Thus, the active area of the solar cell unit is largerthan 100 cm². Such a photovoltaic charger is, for example, useful for charging a tablet.

For example, the electronic device is any of head phones, a tablet, or a mobile phone. For example, the electronic device is head phones comprising a headband for reaching over a wearer's head, wherein the photovoltaic charger is arranged on a top surface of the headband. For example, the electronic device is a tablet, wherein the photovoltaic charger is integrated in the tablet, or in a casing of the tablet. For example, the portable electronic device is a mobile phone, wherein the photovoltaic charger is integrated in the mobile phone or in a casing of the mobile phone.

Another object of the present invention is to provide a method for producing the solar cell unit.

The method comprises:
- preparing a first ink comprising conductive particles,
- preparing a second ink comprising a mixture of conductive particles and catalytic particles,
- providing a porous insulating substrate,
- depositing a first layerof the first ink on a first side of the porous insulating substrate,
- depositing a second layer of the second ink on a second side of the porous insulating substrate,
- sintering the porous insulating substrate with the deposited layers to transform the first layer into a porous first conductive layer and the second layer into a porous catalytic conductive layer, and
- heating the porous insulating substrate with the sintered conductive layers in air to form titanium oxide on the surfaces of the first conductive layer.

The method further comprises arranging a porous light-absorbing layer on top of the porous first conductive layer, infiltrating an ionic-based electrolyte in the porous layers, and sealing the solar cell unit.

At least some of the steps of the method can be carried out in different order, for example, the second layer can be deposited before the first layer. The heating in air can, for example, be done simultaneously as producing the light-absorbing layer on top of the porous first conductive layer.

### Brief description of the drawings

Fig. 1 shows a first example of a dye-sensitized solar cell unit.
Fig. 2 shows a second example of a dye-sensitized solar cell unit.
Fig. 3 shows a view from above on a photovoltaic charger in accordance with one or more embodiments of the invention.
Fig. 4 shows a cross section through the photovoltaic charger shown in figure 3 in an enlarged view.
Fig. 5 shows a diagram of measured values for generated voltage (mV) for light intensities between 200 and 20 000 Lux for the third example of a solar cell unit having an electrolyte comprising iodide and triiodide ions.
Fig. 6 shows a diagram based on measured values for generated current (µA/cm²) for light intensities between 200 and 20 000 Lux for the third example of the solar cell unit.
Fig. 7 shows a diagram based on measured values for generated power per area (µW/cm²) for light intensities between 200 and 20 000 Lux for the third example of the solar cell unit having an electrolyte comprising iodide and triiodide ions.
Fig. 8 shows a diagram of measured values for generated voltage (mV) for light intensities between 200 and 50 000 Lux for a third example of a solar cell unit having an electrolyte comprising copper ions.
Fig. 9 shows a diagram based on measured values for generated current (µA/cm²) for light intensities between 200 and 50 000 Lux for the third example of the solar cell unit having an electrolyte comprising copper ions.
Fig. 10 shows a diagram based on measured values for generated power per area (µW/cm²) for light intensities between 200 and 50 000 Lux for the third example of solar cell unit having an electrolyte comprising copper ions.

### Detailed description of preferred embodiments of the invention

Aspects of the present disclosure will be described more fully hereinafter with reference to the accompanying drawings. The dye-sensitized solar cell unit and the photovoltaic charger disclosed herein can, however, be realized in many different forms and should not be construed as being limited to the aspects set forth herein. Like numbers in the drawings refer to like elements throughout.

The terminology used herein is for the purpose of describing particular aspects of the disclosure only and is not intended to limit the invention.

Unless otherwise defined, all terms used herein have the same meaning as commonly understood by one of ordinary skill in the art to which this disclosure belongs.

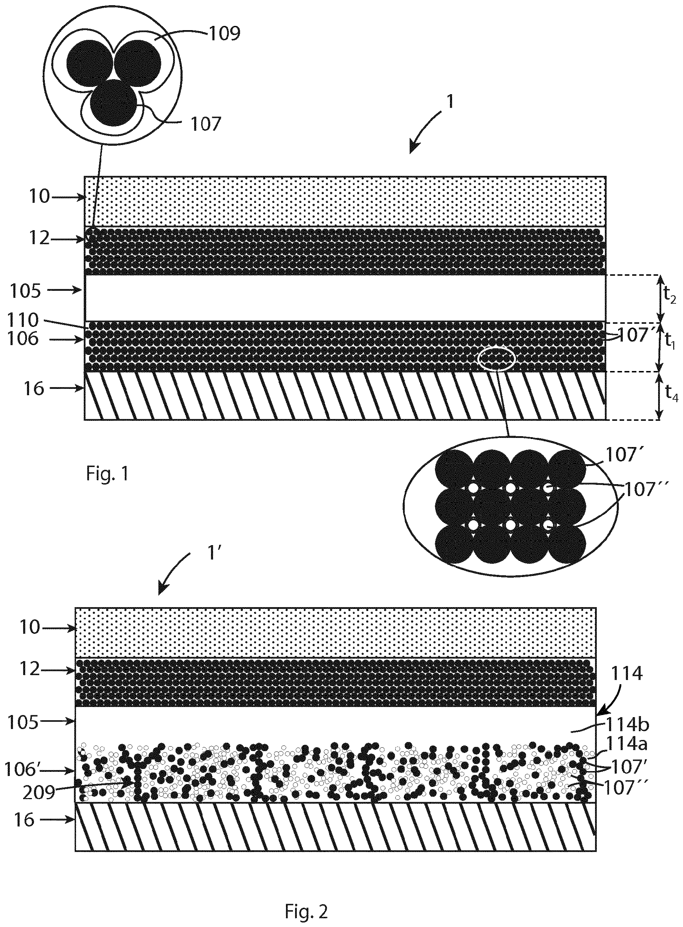

Figure 1 shows an example of a dye-sensitized solar cell unit 1. The solar cell unit 1 comprises a working electrode comprising a light-absorbing layer 10 and a porous first conductive layer 12 for extracting photo-generated electrons from the light-absorbing layer 10. Preferably, the light-absorbing layer 10 is porous. The light-absorbing layer 10 is arranged on top of the first conductive layer 12. The solar cell unit 1 further comprises a porous insulating layer 105 made of an insulating material, wherein the first conductive layer 12 isarrangedon top of the porous insulating layer 105. For example, the porous insulating layer 105 is a porous substrate.

The solar cell unit 1 has a counter electrode comprising a porous catalytic conductive layer 106 comprising porous conductive material 107' and catalytic particles 107" distributed in the porous conductive material 107' for improving the transfer of electrons to an electrolyte 110 disposed in pores of the porous catalytic conductive layer 106. In one aspect, the conductive material 101' of the porous catalytic conductive layer 106 comprises conductive particles 107'. For example, the porous catalytic conductive layer 106 comprises a mixture of conductive particles 107' and catalytic particles 107'', as shown in the enlarged figure to the right in figure 1. Preferably, the catalytic particles 107"are substantially evenly distributed in the conductive material 107' of the catalytic conductive layer 106.

The porous catalytic conductive layer 106 is arranged adjacent to the porous insulating layer 105 on an opposite side of the insulating layer compared to the first conductive layer.

In one aspect, the counter electrode of the solar cell unit 1 comprises a second conductive layer 16 including a conductive material.The porous catalytic conductive layer 106 is disposed between the porous insulating layer 105 and the second conductive layer 16. The catalytic conductive layer 106 is in electrical contact with the second conductive layer 16. The second conductive layer 16 is essentially non-catalytic. The first conductive layer 12, the catalytic conductive layer 106, and the insulating layer 105 are porous to allow the electrolyte to penetrate through the layersto reach the light-absorbing layer 10. In one aspect, the second conductive layer is also porous. In an alternative embodiment, the second conductive layer 16 can be omitted.

The solar cell unit 1 also comprises an ionic based electrolyte 110 for transferring charges between the counter electrode and the working electrode. For example, the ionic based electrolyte is a liquid or a gel. The ionic based electrolyte is located in pores of the porous layers, such as the porous first conductive layer 12, the catalytic conductive layer 106, the porous insulating layer 105, and the light-absorbing layer 10. The ionic based electrolyte may also be located in pores of the second conductive layer 16, if the second conductive layer is porous.

The conductive material in the porous catalytic conductive layer 106 is a part of the counter electrode. Consequently, since the catalytic conductive layer 106 and second conductive layer 16 are in electrical contact, the effective distance between the light-absorbing layer 10 and the second conductive layer 16 is shorter and the resistive losses in the conductive medium are therefore reduced. Further, the catalytic particles 107" facilitating the transfer of electrons from the conductive material 107' in the porous catalytic conductive layer to the electrolyte 110.

In one aspect, the catalytic conductive layer 106 comprises a mixture of conductive particles 107' and catalytic particles 107". The conductive particles are in electrical contact with the second conductive layer 16. Preferably, the conductive particles are non-catalytic and exclude catalytic material. The mixture of conductive particles and catalytic particles will result in efficient transfer of electrons from the catalytic conductive layer to the electrolyte.

The conductive particles of the catalytic conductive layer include conductive material and are in electrical contact with the second conductive layer 16. The catalytic particlesare distributed among the conductive particles. The conductive particles act as a holder for the catalytic particles and keep them in place. The conductive particles may form a matrix for housing the catalytic particles and keeping them in place. For example, the matrix comprises sintered metal particles.

In one aspect, the catalytic particlesare substantially evenly distributed among the conductive particles. By distributing the catalytic particles substantially evenly in the catalytic conductive layer, transfer of electrons from the conductive particles to the electrolyte is improved. In one aspect, the conductive particles are attached to each other, for example, by sintering. The conductive particle may form a matrix housing the catalytic particles. The catalytic particles are embedded in the matrix of conductive particles. For example, the catalytic conductive layer comprises sintered conductive particles, and catalytic particles are disposed between the conductive particles. The conductive particles act as a glue between catalytic particles and keep the catalytic particles in position between the conductive particles.

In one aspect, at least 80% of the catalytic particles 107" have a diameter less than 50 nm. Such small particleshave a large surface/volume ratio and will provide an efficient catalyzation with a reduced volume of catalytic material. If the catalytic material is platina, this will reduce the cost for the catalytic material. In one aspect, at least 80% of the conductive particles have a diameter larger than 100 nm. Preferably, the size of conductive particles is between 0.1 -15 µm.

The conductive material of the first and second conductive layers 12, 16 can, for example, be metal, metal alloy, metal oxide, or other conductive materials, for example, titanium, titanium alloys, nickel, or nickel alloys. Suitably, the first and second conductive layers 12, 16 comprise titanium or an alloy thereof. For example, the conductive material of the first and second conductive layers is titanium. For example, the first conductive layer 12 may comprise sintered titanium particles in order to be porous. It is advantageous to use titanium since it is highly corrosion resistant, and ionic based electrolytes often are very corrosive.

The conductive material 107' in the catalytic conductive layer 106 can, for example, be made of metal, metal alloy, metal oxide, or other conductive materials, for example, titanium, titanium alloys, nickel, or nickel alloys, indium or indium oxide. The catalytic particles 107" are, for example, made of carbon-based materials such as graphene or graphite or carbon black or carbon nanotubes, platina or a combination thereof.

In one aspect, the catalytic particles 107" comprise carbon particles. Carbon is inexpensive and environmentally friendly. More preferably, the catalytic particles 107" include platinized carbon particles. Platina is a better catalyst than carbon, but it is expensive. By using a combination of platina and carbon, a good catalyst is achieved at a lower cost. The catalytic particlescan be electrically conductive as well as catalytic. For example, carbon is electrically conductive as well as catalytic. However, carbon is a poor conductor in comparison to other conductive material, such as titanium.

The electrical conductivity of the first and second conductive layer 12, 16 can be higher than the electrical conductivity of the catalytic conductive layer 106. The combination of a catalytic conductive layer 106 with a mixture of conductive material and catalytic particles, and a second conductive layer 16 essentially without catalytic particles, will result in efficient transfer of electrons from the conductive particles 107' of the counter electrode to the electrolyte as well as high electrical conductivity of the counter electrode.

Preferably, the catalytic conductive layer comprises between 1 - 50 % by weight of catalytic particles. The % by weight of catalytic particles needed to achieve an efficient transfer of electrons from the conductive material to the electrolyte depends on the size and shape of the catalytic particles and the type of material in the catalytic particles and the type of conductive material. For example, the catalytic conductive layer may comprise between 5 -30 % by weight of catalytic particles. This range is, for example, suitable when the conductive particles consist of titanium and the catalytic particles consist of platinized carbon. However, as mentioned before, the % by weight of catalytic particles depends on the size of the particles.

For example, if the conductive material 107' in the catalytic conductive layer 106 is titanium, the catalytic particles 107" comprise platinized carbon, and the size of the catalytic particles 107" is less than the size of the conductive particles 107', the catalytic conductive layer 106 may comprise between 5 - 30 % by weight of catalytic particles 107" to provide an efficient transfer of electrons to the electrolyte. For example, the catalytic conductive layer comprises between 50 and 90 % by weight of titanium, at least 5 % by weight of carbon, and at least 0.001 % by weight of platina. Titanium has good mechanical strength and keeps the platinized carbon particles in their positions in the catalytic conductive layer. Thus, carbon, platina and titanium together provide a catalytic conducting layer with high mechanical strength and a high ability to transfer electrons to the electrolyte.

In one aspect, the thickness t1 of the catalytic conductive layer 106 is at least 1 µm, preferably at least5 µm and most preferably at least 10 µm. In one aspect, the thickness t1 of the catalytic conductive layer 106 is less than 100 µm, and preferably less than 20 µm. In one aspect, the thickness t2 of the porous insulating layer 105 is between 0.1 µm and 20 µm, and preferably between 0.5 µm and 10 µm. In one aspect, the thickness t4 of the second conductive layer 16 is at least 1 µm, preferably at least 10 µm and preferably at least 20 µm.

The first conductive layer 12 comprises an insulating oxide layer 109 formed on the surface of the conductive material, as shown in the enlarged figure to the left in figure 1. This oxide layer 109 is, for example, formed by oxidizing the conductive material of the first conductive layer. The conductive material suitably comprises a metal or a metal alloy, for example, titanium. The surface of the conductive material is oxidized when it is exposed to air. The oxide layer 109 can be formed by performing a heat treatment of the first conductive layer in an oxidizing environment so that the conductive material becomes oxidized. The insulating oxide layer 109 provides an electrically insulating layer on the conductive material, which at least partly prevents transfer of electrons between the first conductive layer 12 and the electrolyte disposed in the pores of the first conductive layer 12.

In one aspect, the first conductive layer 12 comprises porous titanium, and a titanium oxide layer 109 formed on the surfaces of the porous titanium so that the oxide layer 109 electrically insulates the porous titanium of the first conductive layer and by that prevents electrons from leaking from the porous titanium in the first conductive layer to the electrolyte in the pores of the first conductive layer. Thus, the efficiency of the solarcell unit is increased. For example, the first conductive layer 12 comprises sintered titanium particles 107, and the surfaces of the sintered titanium particles 107 are covered by the titanium oxide layer 109, as shown in the enlarged figure to the left in figure 1. In one aspect, the thickness of the titanium oxide layer is larger than 5 nm, preferably larger than 10 nm, and more preferably larger than 20 nm. The thickness of the titanium oxide layer is between 10 and 200 nm, and preferably between 20 - 50 nm.

In particular, the combination of the insulating oxide layer 109 that prevents electrons from leaking from the first conductive layer to the liquid based electrolyte, and a counter electrode comprising a catalytic conductive layer 106 including catalytic particles 107" distributed in a porous conductive material 107, and a non-catalytic conductive layer 16 that improves the efficiency of the counter electrode, will result in an efficient solar cell unit which is capable of producing power in a wide range of different light conditions. The solar cell unit works during poor as well as excellent lighting conditions, for example, indoors in artificial light, and outdoors in the shadow and when exposed to strong sunlight.

In one aspect, the electrolyte is any of a iodide/triiodide electrolyte, a copper complex-based electrolyte, or a cobalt complex-based electrolyte, or a combination thereof. In one aspect, the electrolyte comprises iodide (I⁻) and triiodide (I₃⁻) and the content of triiodide in the conductive medium is between 1 mM and 20 mM. This embodiment makes it possible to achieve high power generation at low light intensities.

The insulating material of the porous insulating layer 105, is, for example, an inorganic material that is positioned between the first conductive layer 12 and the catalytic conductive layer 106, and insulates the first conductive layer 12 and the catalytic conductive layer 106 from each other. The porous insulating layer 105 is, for example, made of glass fibers, ceramic microfibers, or materials derived by delaminating layered crystals such 2D materials or nanosheets.

The solar cell unit 1 may comprise a porous substrate. The porous insulating layer 105 may comprise the whole substrate, as shown in figure 1, or only a part 114a of the porous substrate 114 as shown in figure 2. According to one aspect, the porous substrate is a sheet comprising woven microfibers extending through the entire solar cell unit. For example, the woven microfibers are made of glass fibers.

Figure 2 shows an example of a dye-sensitized solar cell 1' comprising a porous substrate 114 made of an insulating material. Like or corresponding parts in the figures 1 and 2 are indicated with like numerals. The difference between the solar cells 1' and 1 is that the porous catalytic conductive layer 106' comprises a first part 114a of a porous substrate 114, and the porous insulating layer 105 comprises a second part 114b of the porous substrate 114. The catalytic conductive layer 106' comprises conductive particles 107' and catalytic particles 107" disposed in pores of the first part 114a of the porous substrate 114. The conductive particles 107' of the catalytic conductive layer 106' form a conductive network 209 through the insulating material of the part 114a of the porous substrate 114. The conductive network 209 form one or more electrically conductive paths through the insulating material of the first part 114a of porous substrate. The conductive particles 107' and the catalytic particles 107" are disposed in pores of the porous substrate 114. Preferably, the size of the particles is less than the size of the pores in the porous substrate to be able to be infiltrated into the substrate during production of the solar cell. The conductive network 209 provides an extension of the second conductive layer, which extends into the porous substrate 114. Due to the conductive network in the porous substrate, the distance between the counter electrode and the light-absorbing layer does no longer depend on the thickness of the porous substrate. Thus, the thickness of the insulating layercan be reduced, and by that the distance between the counter electrode and the light-absorbing layer can be reduced. Accordingly, the resistive losses in the electrolyte are reduced.

In the following an example of a method for manufacturing the solar cell unit 1 is briefly described.
1) Preparing a first ink comprising conductive particles made of an electrically conductive material. The conductive particles are, for example, made of titanium hydride.
2) Preparing a second ink comprising a mixture of conductive particles and catalytic particles. The conductive particles are, for example, made of titanium hydride (TiHz) and the catalytic particles are, for example, platinized carbon particles.
3) Providing a porous insulating substrate, for example, a glass fabric.
4) Depositing conductive particles on one side of the porous insulating substrate, for example, by printing the first ink including the titanium hydride particles on one side of the porous insulating substrate.
5) The printed first ink is then allowed to dry in air,
6) Depositing a mixture of catalytic particles and conductive particles on the other side of the porous insulating substrate, for example, by printing the second ink including the titanium hydride particles and platinized carbon particles on the other side of the porous insulating substrate.
7) The printed second ink is then allowed to dry in air,
8) Depositing conductive particles on top pf the catalytic conductive layer, for example, by printing the first ink including the titanium hydride particles on the layer of mixture of catalytic particles and conductive particles.
9) The printed first ink is then allowed to dry in air,
10) The porous insulating substrate with the printed layers is then vacuum sintered, for example, at 600 °C for an hour. During the sintering process, the titanium hydride is transformed into titanium. Consequently, a first conductive layer including sintered titanium, a second conductive layer including sintered titanium, and a catalytic conductive layer including sintered titanium and platinized carbon particles disposed in pores between the sintered titanium are formed during the sintering process.
11) The porous insulating substrate with the sintered conductive layers is heated in air to form titanium oxide on the surfaces of the sintered titanium of the first conductive layer.
12) A TiO₂ based ink is printed on top of the first conductive layer and then dried. The glass fabric with the layers is heated, for example, to 600 °C. Consequently, the deposited TiOz layer is sintered.
13) The sintered TiO2 layer is dye-sensitized to form a light-absorbing layer,
14) An ionic electrolyte, for example, an iodide/triiodide (I-/I3)- based redox electrolyte, is infiltrated in the porous layers.
15) The solar cell is sealed, for example, by a transparent encapsulation.

Alternatively, step 11 can be done simultaneously as sintering the TiO2 layer in step 12.

The porous conductive layers can be deposited on the porous substrate by any of screen printing, slot die coating, spraying, or wet laying.

During the heat treatment of step 11, titanium oxide is also formed on the catalytic conductive layer. It could be assumed that the oxide layeron the catalytic conductive layer would prevent the electrons from being transferred between the conductive material and the electrolyte disposed in the pores of the catalytic conductive layer. Surprisingly, it has been discovered that the catalytic particles, for example, platinized carbon particles, enable transfer of electrons from the conductive material to the electrolyte despite the oxide layer on the conductive material of the catalytic conductive layer.

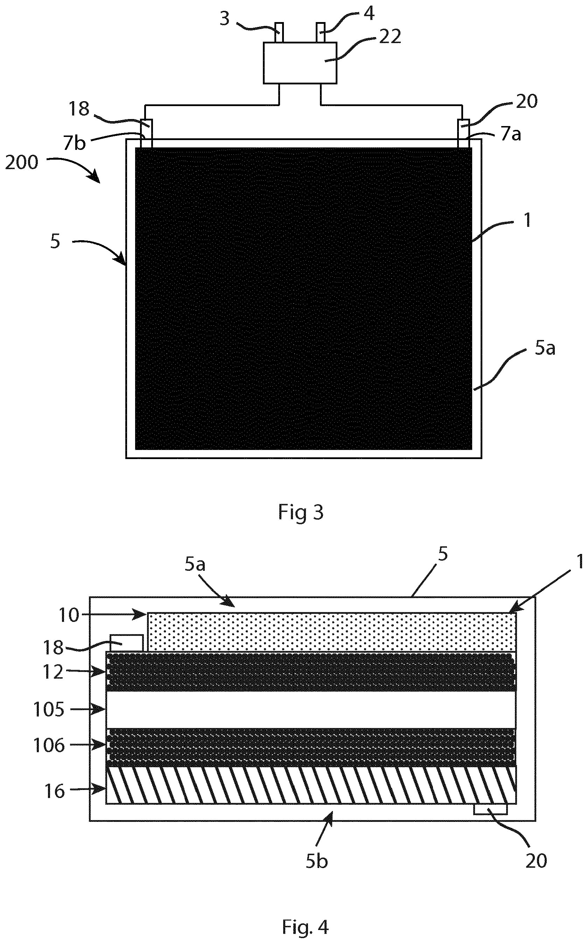

Figure 3 shows a view from above of an example of a photovoltaic charger 200. The photovoltaic charger 200 is specially adapted for powering portable electronic devices that can be used indoors as well as outdoors, such as earphones, laptops, tablets, mobile phones, and remote-control units. The photovoltaic charger 200 can also be used for powering small electronic devices embedded in other physical devices, such as vehicles, and home appliances, called Internet of Things (IoT).

The photovoltaic charger 200 comprises a solar cell unit 1, an encapsulation 5 enclosing the solar cell unit 1, a first conductor 18, and a second conductor 20. The photovoltaic charger may further comprise connection elements (not shown) for connecting the photovoltaic charger 200 to the electronic device. The solar cell unit 200 is a monolithic type DSC. The monolithic type of DSC differs from the standard DSC in that it is created on a single substrate, with multiple layer disposed on the substrate.

The encapsulation comprises a plurality of penetrations in connection to the first and second conductors for connecting the photovoltaic device to the external device. In other words, there are penetrations in the encapsulation for accessing the power produced by the photovoltaic device. Some kind of wiring will be going through the penetrations. For example, the first and second conductors mayextend out of the encapsulation through the penetrations to connect to wiring for powering the external device. Alternatively, wires from the outside of the encapsulation are going through the penetrations and electrically connect to the first and second conductors. The penetrations are tightly fit around the wiring passing through the encapsulation such that no gas or liquid can pass through penetrations. For example, the penetrations are openings in the encapsulation tightly fit around wiring passing through the encapsulation.

The encapsulation 5 comprises a plurality of penetrations 7a- b arranged in connection to the first conductor 18 and the second conductor 20 for connecting the photovoltaic device 1 to the external device and by that accessing the power produced by the photovoltaic device. For example, the penetrations are lead trough openings in the encapsulation. Some kind of wiring will be going through the openings. For example, the first and second conductors 18, 20 may extend out of the encapsulation through the penetrations 7a-b to connect to wiring for powering the external device, as shown in figure 3. Alternatively, wires from the outside of the encapsulation are going through the penetrations and are electrically connected to the first and second conductors. The penetrations are tightly fit around the wiring such that no gas or liquid can pass through them. The penetrations can be made by having the wires or conductors that should go through the holes in place when the encapsulation is arranged on the solar cell unit 1. The encapsulation consists of top sheet 5a and bottom sheet 5b, which are, for example, adhesive filmsthat are put together over the solar cell unit 1. Alternatively, the top and bottom sheets are made of a flexible plastic material, and the edges of the top and bottom sheets are bonded to each other by melting the plastic material. If the wires/conductors are already in place between sheets before the bonding and protrude at the edges of the sheets, the penetrations will be created during the bonding. Alternatively, the penetrations comprise through holes in the encapsulation made after encapsulation of the solar cell unit. The through holes are sealed after the wires/conductors have been arranged in the through holes. The locations of the penetrations will depend on the position of the first and second conductors. The number of penetrations can vary. There is at least one penetration for each of the first and second conductor. However, it is also possible to have a plurality of penetrations for each of the first and second conductors.

Figure 4 shows an enlargement of a cross section through a part of the photovoltaic charger 200 shown in figure 3. The photovoltaic charger 200 comprises one solar cell unit 1, or solar cell unit 1', which is described in more details with reference to figures 1 and 2. For example, the light-absorbing layer 10 comprises dyed TiOz. Conventional dyes known in the art can be used. A dye is chosen to give good efficiency of the solar cell, especially in combination with a copper-based conductive medium. The light-absorbing layer 10 is arranged on top of the first conductive layer 12. The porous light-absorbing layer 10 is a porous TiO₂ layer deposited onto the first conductive layer 12. The TiO₂ layer comprises TiO₂ particles dyed by absorbing dye molecules on the surface of the TiOz particles. The light-absorbing layer 10 is positioned on a top side of the solar cell unit 1. The top side should be facing the light to allow the light to hit the dye molecules of the working electrode.

The first conductive layer 12 is in direct electrical contact with the light-absorbing layer 10. In this example, the second conductive layer 16 is porous. However, in an alternative embodiment, the second conductive layer 16 does not have to be porous. For example, the second conductive layer can be made of a metal foil. In this example, the porous insulating layer 105 comprises at least a part of a porous substrate. The porous substrate provides electrical insulation between the first conductive layer 12 and the catalytic conductive layer 106. The first conductive layer 12 and the catalytic conductive layer 106 are separated physically and electrically by the porous substrate. The porosity of the porous substrate will enable ionic transport through the insulating layer 105. The porosity of the first conductive layer 12 and the catalytic conductive layer 106 will enable ionic transport between the counter electrode and the working electrode.

The photovoltaic charger 200 contains only one single solar cell unit 1. At least the first conductive layer 12 and the porous substrate are continuously extending through the entire solar cell unit. The light-absorbing layer 10 and the second conductive layer 16 extend continuously at least through a main part of solar cell unit.

The solar cell unit 1 is filled with an electrolyte for transferring charges between the counter electrode and the light-absorbing layer 10. The electrolyte is, for example, a conventional I⁻/I⁻³ electrolyte or a similar electrolyte, or a copper (Cu) based electrolyte, or cobalt (Co) complex based electrolyte. The electrolyte comprises ions, for example, iodide ions (I⁻) and triiodide ions (I₃⁻) or copper ions (Cu²⁺ and Cu⁺). Sunlight is harvested by the dye, producing photo-excited electrons that are injected into the conduction band of the TiO₂ particles and further collected by the first conductive layer. At the same time, ions in the electrolyte transport the electrons from the second conductive layer to the light-absorbing layer 10. The first conductor 18 collects the electrons from the first conductive layer and the second conductor provides electrons to the second conductive layersuch that the solar cell unit can continuously produce power from the incoming photons.

The electrolyte penetrates the pores of the light-absorbing layer 10, the first conductive layer 12, the porous insulating layer 105, the second conductive layer 16 and the catalytic conductive layer 106 to allow the ions to be transferred between the light-absorbing layer 10 and the second conductive layer 16 and by that transfer electrons from the working electrode to the light-absorbing layer.

There are many dyes that may be used and according to some aspects, the dye comprises triarylamine organic dye comprising any of, or a mixture of, dyes in the class Donor-π bridge-Acceptor (D-π-A) and in the class Donor-Acceptor-π bridge-Acceptor (D-A-π-A). Such dyes give good efficiency of the solar cell, especially in combination with a copper-based conductive medium. Of the first class photosensitizer are, for example, substituted (diphenylaminophenyl)-thiophene-2-cyanoacrylic acids or substituted (diphenylaminophenyl)cyclopenta-dithiophene-2-cyanoacrylic acids. Of the second class are, for example, substituted (((diphenylaminophenyl)benzothia-diazolyl)-cyclopentadithiophenyl)aryl/heteroaryl-2-cyanoacrylic acids or (((diphenyl-aminophenyl)-cyclopentadithiophenyl)benzothiadiazolyl)aryl/heteroaryl-2-cyano-acrylic acids.

The first conductor 18 is electrically connected to the first conductive layer 12, and the second conductor 20 is electrically connected to the second conductive layer 16. For example, the first and second conductors are made of metal to achieve high electrical conductivity.

The encapsulation 5 comprises a top sheet 5a covering a top side of the solar cell unit 1, and a bottom sheet 5b covering a bottom side of the solar cell unit. The encapsulation 5 encloses the solar cell unit and the electrolyte and acts as liquid barrier for the electrolyte and prevents the electrolyte from leaking from the photovoltaic charger 200. The top sheet 5a is transparent, or at least the part covering the active area of the solar cell unit 1 is transparent. The top sheet 5a on the top side of the solar cell unit covers the light-absorbing layer 10 and allows light to pass through. The top and bottom sheets 5a-b are, for example, made of a polymer material. A polymer material is robust and impact resistant, and flexible. The top and bottom sheets 5a-b are sealed at the edges in order to protect the solar cell unit against the surrounding atmosphere, and to prevent the evaporation or leakage of the electrolyte from the inside of the solar cell unit.

In one example, the porous substrate is a sheet comprising a fabric of woven microfibers. A microfiber is a fibre having a diameter less than 10 µm and larger than 1 nm. A fabric of wove n microfibers can be made very thin and mechanically very strong. The fabric of woven microfibers contains holes between the woven yarns. The porous substrate may further comprise one or more layers of non-woven microfibers disposed on the woven microfibers to at least partly block the holes between the yarns. Further, the non-woven layer provides a smooth surface on the substrate, suitable for applying a smooth conductive layer on the substrate by printing. The substrate is, for example, made of glass, silica (SiO₂), alumina (Al₂O₃), aluminosilicate or quartz. Suitably, the non-woven and woven microfibers of the porous substrate are made of glass fibres, which provides a robust and flexible substrate. The thickness of the fabric of woven microfibers is suitably between 4 µm and 30 µm, preferably between 4 µm and 20 µm to provide the required mechanical strength at the same time as it is thin enough to enable a fast transport of ions between the counter electrode and working electrode.

In one aspect, light-absorbing layer 10, and the first conductive layer 12 are non-transparent. In this example, the upper surface of the solar cell unit 1 is homogeneously black, as shown in figure 3. The TiOz of the light-absorbing layer is black. There are no conductors extending across the surface of the solar cell unit 1 as it is in the prior art solarcell panels. This is because the photovoltaic charger 200 only contains one single solar cell unit, and not a plurality of series connected solar cell units, as in the solar panels used in the prior art photovoltaic chargers.

The size of the solar cell unit, i.e. the length and width of the solar cell unit, may vary depending on which device it is adapted to charge. Accordingly, the active area of the solar cell unit may vary depending on the need of power for the device to charge. There is no limit to the possible shape and size of the solar cell unit. For example, the size of the solar cell unit may vary between 1×1 cm with an active area of 1 cm² and 1×1 m with an active area of 1 m². There is no upper limitto the length and width of the solar cell unit. However, a solar cell unit larger than 1×1 m can be bulky to handle during manufacturing of the solar cell unit.

The photovoltaic charger 200 includes a single solar cell unit 1 and a boost converter 22 electricallyconnected to the first and second conductors 18, 20. A boost converter, also called step-up converter or step-up regulator, is a DC-to-DC power converter that steps up voltage while stepping down current from its input to its output. The voltage produced by the single solar cell unit is too low to charge certain types or batteries, for example, lithium batteries that require at least 3.6 V. The boost converter is adapted to step up the voltage from the solar cell unit 1 while stepping down the current from the solar cell unit. The required voltage level is achieved by connecting a boost converter to the single solar cell unit. Thus, it is possible to provide a photovoltaic charger having only one single solar cell unit capable to charge batteries that require different voltage levels.

The photovoltaic charger 200 comprises connection elements 3, 4 for connecting the photovoltaic charger to a battery of the electronic device, which it is charging. The boost converter 22 comprises input terminals electrically connected to the first and second conductors 18, 20 and output terminals electrically connected to the connection elements 3, 4.

The level of the generated voltage depends on the ions in the electrolyte. For example, if the electrolyte contains copper ions, the solar cell unit generates a voltage of about 1V in an open circuit when the light intensity received by the light-absorbing layer is 20 000 Lux, and if the electrolyte contains iodide and triiodide ions, the solar cell unit generates a voltage of about 0.65 V in an open circuit when the light intensity received by the light-absorbing layer is 20 000 Lux. However, the solar cell unit 1 generates a voltage varying at most 0.4 V in an open circuit when the light intensity received by the light-absorbing layer is varying between 200 and 20000 Lux. The requirement on the voltage conversion of the boost converter depends on the voltage requirement of the rechargeable battery. Most types of rechargeable batteries used for electronic devices for consumer applications require a voltage between 1 and 10 V. The boost converter makes it possible to generate a stable voltage at a level required by the rechargeable battery. Preferably, the boost converter 22 is capable to convert the output voltage and current from the solar cell unit to a voltage level that lies between 1 and 10 V. Different boost converters can be used depending on the required output voltage. Thus, the photovoltaic charger is capable to charge batteries used for many types of electronic devices, such as lithium batteries (3.6V), NiCd and NiMH batteries (1.25 V).

From tests it has been shown that the solar cell unit is capable to produce a current of at least 15 µA/cm² when the light intensity received by the light-absorbing layer is 200 Lux, and a current of at least 1500 µA/cm² when the light intensity received by the light-absorbing layer is 20 000 Lux. Thus, the solar cell unit is capable to produce sufficient power to charge batteries of electronic devices in a wide range of light intensities.

According to some aspects, at least the first conductive layer 12 and the porous substrate 114 are continuously extending through the entire solar cell unit 1. The light-absorbing layer 10 and the second conductive layer 16 extend continuously at least through a main part of the solar cell unit.

Measurements of generated power per area for different light conditions have been made on an example of a photovoltaic charger of the invention including one single solar cell unit 1. In this example, the solar cell unit 1 has a size of 14.5 × 23.4 cm, and an active area of 340 cm². The electrolyte of the solar cell unit 1 comprises iodide and triiodide ions, and the first and second conductive layers are made of titanium (Ti). The unloaded photovoltaic charger is exposed with light between 200 and 20 000 Lux (lumen per square meter), and the output voltage and output current from the photovoltaic charger is measured. The results of the measurements are shown in table 1 below. The total power generated is determined based on the measured current and voltage, and the generated power per area is determined by dividing the total power with the active area of the solar cell unit.

**Table 1 Measurements of generated power per active area, current per active area, voltage and fill factors (ff) for light intensities between 200 - 20 000 Lux for a solar cell unit 1 having an electrolyte comprising iodide (I⁻) and triiodide (I₃⁻) ions. The content of triiodide is between 1 mM and 20 mM. Iodide works as ox and triiodide works as red.**

| Lux | µW/cm² | I sc (µA/cm²) | Voc (mV) | ff (%) |
|---|---|---|---|---|
| 200 | 6,2 | 18 | 483 | 72 |
| 500 | 18 | 44 | 521 | 77 |
| 1000 | 37 | 90 | 542 | 76 |
| 2000 | 80 | 179 | 565 | 79 |
| 3000 | 123 | 266 | 576 | 80 |
| 5000 | 208 | 445 | 591 | 79 |
| 6000 | 249 | 531 | 600 | 78 |
| 10000 | 405 | 880 | 614 | 75 |
| 20000 | 730 | 1700 | 650 | 69 |

The measurements of the performance of the solar cell unit 1 at different light intensities (intensities measured in Lux units) can be done by shining light on the solar cell unit, and simultaneously scanning an applied electrical voltage across the solar cell unit to measure and collect the current-voltage response of the solar cell. The measurements were performed using a warm - white LED as light source.

The collected IV curve under illumination provides information about the open circuitvoltage, short circuit current, fill factor, the power and the power conversion efficiency. By collecting IV curves at different light intensities, it is possible to gather information on the light intensity dependence of the open circuit voltage, short circuit current, fill factor the power and the power conversion efficiency, respectively.

The result from table 1 is from measurements on a sample of a solar cell unit 1. Measurements on different solar cell units of this type may vary. For example, the generated power per area may from 5 µW/cm² to 8 µW/cm².

The light source used for shining light on the solar cell can vary depending on the solar cell application. For indoor applications it could be useful to use fluorescent light bulbs or indoor LED lighting. For solar cell applications that use outdoor light it could be useful to shine light on the solar cell using a solar simulator to generate artificial sunlight.

The light intensity of the light source can be measured in different ways, for example, using a lux meter or a spectroradiometer positioned at the same position as the solar cell unit in relation to the light source. In this case, the light intensity was measured using a lux meter.

Table 1 shows the determined power in microwatt per square centimetre (µW/cm²) for different light intensities measured in lux. As seen from the table, the solar cell unit 1 generates 6.2 µW/cm² when the light intensity received by the solar cell unit 1 is 200 Lux, generates 208 µW/cm² when the light intensity received by the solar cell unit 1 is 5000 Lux, and generates 730 µW/cm² when the light intensity received by the solar cell unit 1 is 20000 Lux. This shows that the photovoltaic charger is capable of producing more than 5 µW/cm², and even more than 5.5 µW/cm² when the light intensity received by the light-absorbing layer is 200 Lux. This also shows that the photovoltaic charger is capable of producing more than 700 µW/cm² when the light intensity received by the light-absorbing layer is 20 000 Lux. Thus, the solar cell unit 1 is at least capable of producing between 5,5 and 700 µW/cm² when the light intensity received by the light-absorbing layer is between 200 and 20 000 Lux. The power produced by the photovoltaic charger increases substantially linear when the light intensity received by the light-absorbing layer increases from 200 to 20 000 Lux. Thus, the photovoltaic charger is capable of producing power in a wide range of different light conditions.

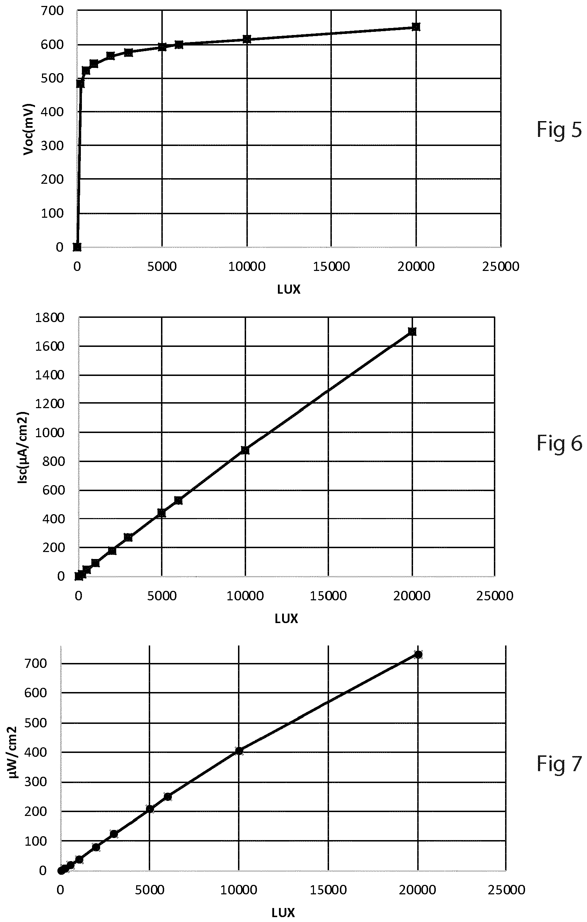

Figure 5 shows a diagram of generated voltage (mV) for light intensities between 200 and 20 000 Lux based on the measured values of table 1. As seen from the diagram and table 1, the solar cell unit 1 is capable to generate a voltage of 480 mV in an open circuit when the light intensity received by the solar cell unit 1 is 200 Lux. Further, the photovoltaic charger 200 is capable to generate a voltage of 650 mV in an open circuit when the light intensity received by the solar cell unit 1 is 20000 Lux. As seen from the diagram, the increase of generated voltage is largest between 200 and 3000 Lux. The generated voltage is substa ntially linear between 3000 and 20 000 Lux. As seen from the table 1, the difference in generated voltage between 200 and 20 000 Lux is only 167 mV. Thus, the solar cell unit 1 generates a voltage varying less than 0.2 V in an open circuit when the light intensity received by the light-absorbing layer is varying between 200 and 20000 Lux. Accordingly, the difference in generated voltage between 200 and 20 000 Lux is about 35%.

Figure 6 shows a diagram of generated current (µA/cm²) for light intensities between 200 and 20000 Lux based on the measured values of table 1. As seen from the figure, the current increase linearly.

Figure 7 shows a diagram of generated power per area (µW/cm²) for light intensities between 200 and 20 000 Lux calculated based on the measured values of voltage and current of table 1. As seen from the diagram, the measured power is substantially proportional to the incoming light intensity in the interval 200 - 20000 Lux.

Further measurements of generated power per area for different light conditions have been made on another example of a photovoltaic charger of the invention. In this example, the electrolyte of the solar cell unit 1 comprises copper ions (Cu⁺ and Cu²⁺), which is the only difference between the photovoltaic chargers measured. The measurement conditions were the same. The unloaded photovoltaic charger 200 is exposed with light between 200 and 20000 Lux (lumen per square meter), and the output voltage and output current from the photovoltaic charger is measured. The result of the measurements is shown in the table 2 below.

**Table 2 Measurements of generated power per area, current per area, voltage and fill factor (ff) for light intensities between 200 - 20 000 Lux for a solar cell unit 1 having an electrolyte comprising copper ions; Cu⁺as red and Cu²⁺as ox.**

| Lux | µW/cm² | I sc (µA/cm²) | Voc (mV) | ff (%) |
|---|---|---|---|---|
| 0 | 0 | 0 | 0 | 0 |
| 200 | 12,8 | 25 | 699 | 72,7 |
| 500 | 38 | 67 | 762 | 74,3 |
| 1000 | 85,4 | 140 | 800 | 76,1 |
| 2000 | 186 | 290 | 835 | 77,1 |
| 5000 | 498 | 737 | 881 | 76,6 |
| 10000 | 1020 | 1490 | 915 | 75,1 |
| 20000 | 2020 | 2960 | 943 | 72,3 |
| 30000 | 2920 | 4390 | 954 | 69,7 |
| 40000 | 3720 | 5750 | 958 | 67,6 |
| 50000 | 4410 | 7000 | 958 | 65,8 |

As seen from the table 2, the solar cell unit 1 generates 12.8 µW/cm² when the light intensity received by the solar cell unit 1 is 200 Lux, generates 498 µW/cm² when the light intensity received by the solar cell unit 1 is 5000 Lux, and generates 2020 µW/cm² when the light intensity received by the solar cell unit 1 is 20 000 Lux. This shows that this photovoltaic charger 200 is capable of producing more than 12 µW/cm² when the light intensity received by the light-absorbing layer 10 is 200 Lux. This also shows that the photovoltaic charger 200 is capable of producing more than 2000 µW/cm² when the light intensity received by the light-absorbing layer 10 is 20 000 Lux. The power produced by the photovoltaic charger increases substantially linear when the light intensity received by the light-absorbing layer increases from 200 to 20 000 Lux. Thus, the photovoltaic charger 200 is capable of producing power in a wide range of different light conditions.

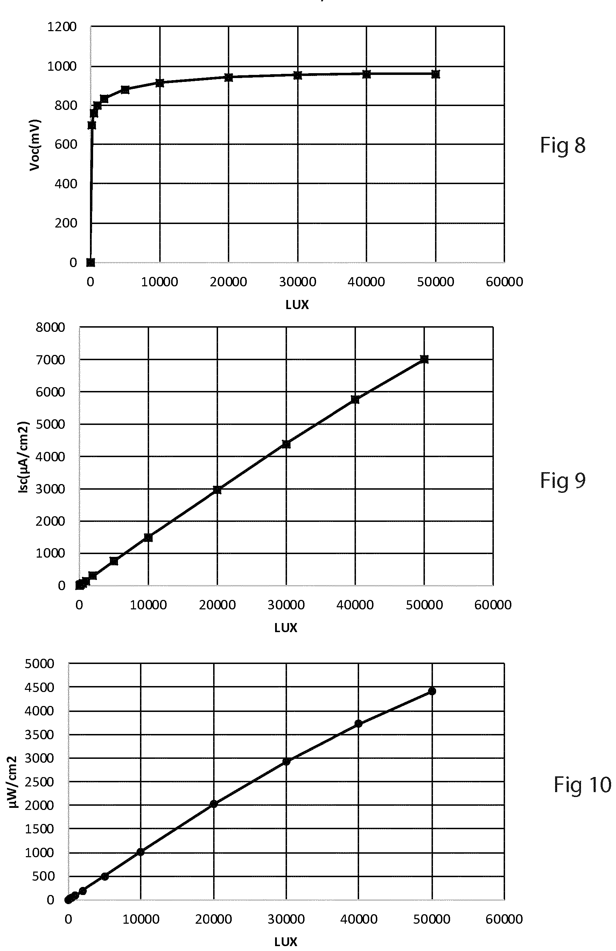

Figure 8 shows a diagram of generated voltage (mV) for light intensities between 200 and 50 000 Lux based on the measured values of table 2. As seen from the diagram and table 2, the solar cell unit 1 is capable of generating a voltage of 699 mV in an open circuit when the light intensity received by the solar cell unit 1 is 200 Lux. Further, the photovoltaic charger 200 is capable to generate a voltage of 943 mV in an open circuit when the light intensity received by the solar cell unit 1 is 20000 Lux. As seen from the diagram, the generated voltage is substantially linear between 3000 and 50 000 Lux. As seen from the table 2, the difference in generated voltage between 200 and 20 000 Lux is only 244 mV. Accordingly, the difference in generated voltage between 200 and 20 000 Lux is about 35%. The difference in generated voltage between 200 and 50 000 Lux is only 259 mV. Thus, the solar cell unit 1 generates a voltage varying less than 300 mV in an open circuit when the light intensity received by the light-absorbing layer is varying between 200 and 50 000 Lux. Accordingly, the difference in generated voltage between 200 and 50 000 Lux is about 37%.

Figure 9 shows a diagram of generated current (µA/cm²) for light intensities between 200 and 50000 Lux based on the measured values of table 2. As seen from the figure, the current increases linearly.

Figure 10 shows a diagram of generated power per area (µW/cm²) for light intensities between 200 and 50 000 Lux calculated based on the measured values of voltage and current of table 1. As seen from the diagram, the measured power is substantially proportional to the incoming light intensity in the interval 200 - 20000 Lux.

The present invention is not limited to the embodiments disclosed but may be varied and modified within the scope of the following claims. For example, the second conductive layer 16 can be omitted. Omitting the second conductive layer may reduce the range of different light conditions in which the solar cell unit can produce enough power for powering a device. However, in some applications the light conditions do no vary that much and a solar cell unit capable to produce power in a smaller range is enough.

## Claims

1. A dye-sensitized solar cell unit (1;1') comprising:
- a working electrode comprising a porous light-absorbing layer (10),
- a porous first conductive layer (12) including conductive material for extracting photo-generated electrons from the light-absorbing layer (10), wherein the light-absorbing layer is arranged on top of the first conductive layer,
- a porous insulating layer (105) made of an insulating material, wherein the first conductive layer (12) is formed on one side of the porous insulating layer (105),
- a counter electrode comprising a porous catalytic conductive layer (106; 106') formed on the opposite side of the porous insulating layer (105), and
- an ionic based electrolyte for transferring electrons from the counter electrode to the working electrode and arranged in pores of the porous first conductive layer (12), the porous catalytic conductive layer (106; 106'), and the porous insulating layer (105), wherein the first conductive layer (12) comprises an insulating oxide layer (109) formed on the surfaces of the conductive material, and the porous catalytic conductive layer (106; 106') comprises conductive material (107') and catalytic particles (107") distributed in the conductive material (107') for improving the transfer of electrons from the conductive material to the electrolyte, **characterized in that** the thickness of said insulating oxide layer (109) is between 10 and 200 nm, such that the solar cell unit (1;1') generates a voltage varying less than 40% when the light intensity received by the light-absorbing layer (10) is varying between 200 and 50 000 Lux.

2. The dye-sensitized solar cell unit according to claim 1, wherein the catalytic particles (107") are evenly distributed in the conductive material (107') of the porous catalytic conductive layer (106; 106').

3. The dye-sensitized solar cell unit according to any of the previous claims, wherein the conductive material (107') of the porous catalytic conductive layer (106) forms a porous matrix and the catalytic particles (107") are distributed in the porous matrix.

4. The dye-sensitized solar cell unit according to any of the previous claims, wherein said catalytic conductive layer (106; 106') comprises between 1 - 50% by weight of catalytic particles (107").

5. The dye-sensitized solar cell unit according to any of the previous claims, wherein the counter electrode comprises a second conductive layer (16) including conductive material in electrical contact with the porous catalytic conductive layer (106; 106'), wherein the second conductive layer (16) is essentially non-catalytic, and the porous catalytic conductive layer (106; 106') is disposed between the porous insulating layer (105) and the second conductive layer (16).

6. The dye-sensitized solar cell unit according to any of the previous claims, wherein said conductive material (107') of the first conductive layer (12) is titanium, and said insulating oxide layer (109) is titanium oxide formed on the surfaces of the titanium.

7. The dye-sensitized solar cell unit according to any of the previous claims, wherein said catalytic particles (107") are platinized carbon particles.

8. The dye-sensitized solar cell unit according to any of the previous claims, wherein said conductive material (107') of the porous catalytic conductive layer (106; 106') is titanium.

9. The dye-sensitized solar cell unit according to any of the previous claims, wherein said conductive material (107') of the porous catalytic conductive layer (106; 106') is titanium, said catalytic particles (107") are platinized carbon particles, and the porous catalytic conductive layer comprises between 50 and 90 % by weight of titanium, at least 5 % by weight of carbon, and at least 0.001 % by weight of platina.

10. The dye-sensitized solar cell unit according to any of the previous claims, wherein at least 80% of said catalytic particles (107") have a diameter less than 50 nm.

11. The dye-sensitized solar cell unit according to any of the previous claims, wherein the thickness of said insulating oxide layer (109) is between 20 - 50 nm.

12. The dye-sensitized solar cell unit according to claim 1, wherein a first conductor (18) is electrically connected to the first conductive layer (12), and a second conductor (20) is electrically connected to the second conductive layer (16).

13. A photovoltaic charger (200) specially adapted for charging an electronic device, comprising:
- a dye-sensitized solar cell unit (1,1') according to claim 1,
- an encapsulation (5) encapsulating the solar cell unit,
- a first conductor (18) electrically connected to the first conductive layer (12), and
- at least one second conductor (20) electrically connected to the second conductive layer (16), wherein the photovoltaic charger (200) contains only one single solar cell unit (1,1') and a boost converter (22) electrically connected to the first and second conductors (18, 20), and the boost converter is adapted to step up the voltage from the solar cell unit while stepping down the current from the solar cell unit.

## Patentansprüche

1. Farbstoffsensibilisierte Solarzelleneinheit (1;1'), umfassend:
- eine Arbeitselektrode, umfassend eine poröse lichtabsorbierende Schicht (10),
- eine poröse erste leitfähige Schicht (12) einschließlich leitfähigem Material zum Extrahieren photoerzeugter Elektronen aus der lichtabsorbierenden Schicht (10), wobei die lichtabsorbierende Schicht auf der ersten leitfähigen Schicht angeordnet ist,
- eine poröse Isolierschicht (105), die aus einem Isoliermaterial hergestellt ist, wobei die erste leitfähige Schicht (12) auf einer Seite des porösen Isoliermaterials (105) ausgebildet ist,
- eine Gegenelektrode, umfassend eine poröse katalytische leitfähige Schicht (106; 106'), die auf der gegenüberliegenden Seite der porösen Isolierschicht (105) ausgebildet ist, und
- einen ionenbasierten Elektrolyten zum Übertragen von Elektronen von der Gegenelektrode zu der Arbeitselektrode und der in Poren der porösen ersten leitfähigen Schicht (12), der porösen katalytischen leitfähigen Schicht (106; 106') und der porösen Isolierschicht (105) angeordnet ist, wobei die erste leitfähige Schicht (12) eine isolierende Oxidschicht (109) umfasst, die auf den Oberflächen des leitfähigen Materials ausgebildet ist, und die poröse katalytische leitfähige Schicht (106; 106') leitfähiges Material (107') und katalytische Teilchen (107') umfasst, die in dem leitfähigen Material (107') zum Verbessern der Übertragung von Elektronen von dem leitfähigen Material zu dem Elektrolyt verteilt sind, **dadurch gekennzeichnet, dass** die Dicke der isolierenden Oxidschicht (109) zwischen 10 und 200 nm liegt, sodass die Solarzelleneinheit (1;1') eine Spannung erzeugt, die weniger als 40 % variiert, wenn die durch die lichtabsorbierende Schicht (10) empfangene Lichtintensität zwischen 200 und 50.000 Lux variiert.

2. Farbstoffsensibilisierte Solarzelleneinheit nach Anspruch 1, wobei die katalytischen Teilchen (107") in dem leitfähigen Material (107') der porösen katalytischen leitfähigen Schicht (106;106') gleichmäßig verteilt sind.

3. Farbstoffsensibilisierte Solarzelleneinheit nach einem der vorstehenden Ansprüche, wobei das leitfähige Material (107') der porösen katalytischen leitfähigen Schicht (106) eine poröse Matrix ausbildet und die katalytischen Teilchen (107") in der porösen Matrix verteilt sind.

4. Farbstoffsensibilisierte Solarzelleneinheit nach einem der vorstehenden Ansprüche, wobei die katalytische leitfähige Schicht (106; 106') zwischen 1 bis 50 Gew.-% katalytische Teilchen (107") umfasst.

5. Farbstoffsensibilisierte Solarzelleneinheit nach einem der vorstehenden Ansprüche, wobei die Gegenelektrode eine zweite leitfähige Schicht (16) umfasst, die leitfähiges Material in elektrischem Kontakt mit der porösen katalytischen leitfähigen Schicht (106; 106') einschließt, wobei die zweite leitfähige Schicht (16) im Wesentlichen nicht-katalytisch ist und die poröse katalytische leitfähige Schicht (106; 106') zwischen der porösen Isolierschicht (105) und der zweiten leitfähigen Schicht (16) eingerichtet ist.

6. Farbstoffsensibilisierte Solarzelleneinheit nach einem der vorstehenden Ansprüche, wobei das leitfähige Material (107') der ersten leitfähigen Schicht (12) Titan ist und die isolierende Oxidschicht (109) Titanoxid ist, das auf den Oberflächen des Titans ausgebildet ist.

7. Farbstoffsensibilisierte Solarzelleneinheit nach einem der vorstehenden Ansprüche, wobei die katalytischen Teilchen (107") platinierte Kohlenstoffteilchen sind.

8. Farbstoffsensibilisierte Solarzelleneinheit nach einem der vorstehenden Ansprüche, wobei das leitfähige Material (107') der porösen katalytischen leitfähigen Schicht (106; 106') Titan ist.

9. Farbstoffsensibilisierte Solarzelleneinheit nach einem der vorstehenden Ansprüche, wobei das leitfähige Material (107') der porösen katalytischen leitfähigen Schicht (106; 106') Titan ist, wobei die katalytischen Teilchen (107") platinierte Kohlenstoffteilchen sind und die poröse katalytische leitfähige Schicht zwischen 50 und 90 Gew.-% Titan, mindestens 5 Gew.-% Kohlenstoff und mindestens 0,001 Gew.-% Platin umfasst.

10. Farbstoffsensibilisierte Solarzelleneinheit nach einem der vorstehenden Ansprüche, wobei mindestens 80 % der katalytischen Teilchen (107") einen Durchmesser von weniger als 50 nm aufweisen.

11. Farbstoffsensibilisierte Solarzelleneinheit nach einem der vorstehenden Ansprüche, wobei die Dicke der isolierenden Oxidschicht (109) zwischen 20 bis 50 nm liegt.

12. Farbstoffsensibilisierte Solarzelleneinheit nach Anspruch 1, wobei ein erster Leiter (18) mit der ersten leitfähigen Schicht (12) elektrisch verbunden ist, und ein zweiter Leiter (20) mit der zweiten leitfähigen Schicht (16) elektrisch verbunden ist.

13. Photovoltaikladegerät (200), das speziell zum Laden einer elektronischen Vorrichtung angepasst ist, umfassend:
- eine farbstoffsensibilisierte Solarzelleneinheit (1,1') nach Anspruch 1,
- eine Verkapselung (5), die die Solarzelleneinheit verkapselt,
- einen ersten Leiter (18), der mit der ersten leitfähigen Schicht (12) elektrisch verbunden ist, und
- mindestens einen zweiten Leiter (20), der mit der zweiten leitfähigen Schicht (16) elektrisch verbunden ist, wobei das Photovoltaikladegerät (200) nur eine einzelne Solarzelleneinheit (1,1') und einen Aufwärtswandler (22) enthält, der mit dem ersten und dem zweiten Leiter (18, 20) elektrisch verbunden ist, und der Aufwärtswandler angepasst ist, um die Spannung von der Solarzelleneinheit zu erhöhen, während der Strom von der Solarzelleneinheit heruntergefahren wird.

## Revendications

1. Unité de cellule solaire à colorant (1 ; 1') comprenant :
- une électrode de travail comprenant une couche poreuse d'absorption de lumière (10),
- une première couche conductrice poreuse (12) incluant un matériau conducteur pour extraire de la couche d'absorption de lumière (10) des électrons photogénérés, la couche d'absorption de lumière étant agencée au-dessus de la première couche conductrice,
- une couche isolante poreuse (105) constituée d'un matériau isolant, dans laquelle la première couche conductrice (12) est formée sur un côté de la couche isolante poreuse (105),
- une contre-électrode comprenant une couche conductrice catalytique poreuse (106 ; 106') formée sur le côté opposé de la couche isolante poreuse (105), et
- un électrolyte à base ionique pour transférer des électrons à partir de la contre-électrode à l'électrode de travail et agencé dans des pores de la première couche conductrice poreuse (12), la couche conductrice catalytique poreuse (106 ; 106') et la couche isolante poreuse (105), dans laquelle la première couche conductrice (12) comprend une couche d'oxyde isolante (109) formée sur les surfaces du matériau conducteur, et la couche conductrice catalytique poreuse (106 ; 106') comprend un matériau conducteur (107') et des particules catalytiques (107") réparties dans le matériau conducteur (107') pour améliorer le transfert d'électrons à partir du matériau conducteur jusqu'à l'électrolyte, **caractérisé en ce que** l'épaisseur de ladite couche d'oxyde isolante (109) va de 10 à 200 nm, de telle sorte que l'unité de cellule solaire (1 ; 1') génère une tension variant de moins de 40 % lorsque l'intensité lumineuse reçue par la couche d'absorption de lumière (10) varie entre 200 et 50 000 lux.

2. Unité de cellule solaire à colorant selon la revendication 1, dans laquelle les particules catalytiques (107") sont uniformément réparties dans le matériau conducteur (107') de la couche conductrice catalytique poreuse (106 ; 106').

3. Unité de cellule solaire à colorant selon l'une quelconque des revendications précédentes, dans laquelle le matériau conducteur (107') de la couche conductrice catalytique poreuse (106) forme une matrice poreuse et les particules catalytiques (107") sont réparties dans la matrice poreuse.

4. Unité de cellule solaire à colorant selon l'une quelconque des revendications précédentes, dans laquelle ladite couche conductrice catalytique (106 ; 106') comprend entre 1 et 50 % en poids de particules catalytiques (107").

5. Unité de cellule solaire à colorant selon l'une quelconque des revendications précédentes, dans laquelle la contre-électrode comprend une seconde couche conductrice (16) incluant un matériau conducteur en contact électrique avec la couche conductrice catalytique poreuse (106 ; 106'), dans laquelle la seconde couche conductrice (16) est essentiellement non catalytique, et la couche conductrice catalytique poreuse (106 ; 106') est disposée entre la couche isolante poreuse (105) et la seconde couche conductrice (16).

6. Unité de cellule solaire à colorant selon l'une quelconque des revendications précédentes, dans laquelle ledit matériau conducteur (107') de la première couche conductrice (12) est du titane, et ladite couche d'oxyde isolante (109) est de l'oxyde de titane formé sur les surfaces du titane.

7. Unité de cellule solaire à colorant selon l'une quelconque des revendications précédentes, dans laquelle lesdites particules catalytiques (107") sont des particules de carbone platiné.

8. Unité de cellule solaire à colorant selon l'une quelconque des revendications précédentes, dans laquelle ledit matériau conducteur (107') de la couche conductrice catalytique poreuse (106 ; 106') est du titane.

9. Unité de cellule solaire à colorant selon l'une quelconque des revendications précédentes, dans laquelle ledit matériau conducteur (107') de la couche conductrice catalytique poreuse (106 ; 106') est du titane, lesdites particules catalytiques (107") sont des particules de carbone platiné, et la couche conductrice catalytique poreuse comprend entre 50 et 90 % en poids de titane, au moins 5 % en poids de carbone, et au moins 0,001 % en poids de platine.

10. Unité de cellule solaire à colorant selon l'une quelconque des revendications précédentes, dans laquelle au moins 80 % desdites particules catalytiques (107") ont un diamètre inférieur à 50 nm.

11. Unité de cellule solaire à colorant selon l'une quelconque des revendications précédentes, où l'épaisseur de ladite couche d'oxyde isolante (109) est entre 20 et 50 nm.

12. Unité de cellule solaire à colorant selon la revendication 1, dans laquelle un premier conducteur (18) est connecté électriquement à la première couche conductrice (12), et un second conducteur (20) est connecté électriquement à la seconde couche conductrice (16).

13. Chargeur photovoltaïque (200) spécialement conçu pour charger un dispositif électronique, comprenant :
- une unité de cellule solaire à colorant (1, 1') selon la revendication 1,
- une encapsulation (5) encapsulant l'unité de cellule solaire,
- un premier conducteur (18) connecté électriquement à la première couche conductrice (12), et
- au moins un second conducteur (20) connecté électriquement à la seconde couche conductrice (16), dans lequel le chargeur photovoltaïque (200) contient une seule unité de cellule solaire (1, 1') et un convertisseur élévateur (22) connecté électriquement aux premier et second conducteurs (18, 20), et le convertisseur élévateur est conçu pour élever la tension provenant de l'unité de cellule solaire tout en diminuant le courant provenant de l'unité de cellule solaire.
